# EUROPÄISCHE PATENTSCHRIFT

(11) **EP 3 598 628 B1**
(45) Veröffentlichungstag und Bekanntmachung des Hinweises auf die Patenterteilung: **22.06.2022**
(21) Anmeldenummer: 19184037.0
(22) Anmeldetag: 03.07.2019
(51) Int. Cl.: H02M 7/483, H02M 7/49, H01L 23/04, H01L 23/473, H01L 25/07, H01L 25/11, H02M 1/32

(54) **HALBLEITERANORDNUNG, SCHALTMODUL MIT DER HALBLEITERANORDNUNG UND MODULARER MEHRSTUFENUMRICHTER MIT DEM SCHALTMODUL**
SEMICONDUCTOR ASSEMBLY, CIRCUIT MODULE COMPRISING THE SEMICONDUCTOR ASSEMBLY AND MODULAR MULTILEVEL CONVERTER WITH THE CIRCUIT MODULE
DISPOSITIF DE SEMI-CONDUCTEUR, MODULE DE COMMUTATION POURVU DE DISPOSITIF DE SEMI-CONDUCTEUR ET CONVERTISSEUR MODULAIRE À PLUSIEURS ÉTAGES POURVU DE MODULE DE COMMUTATION

(30) Priorität: 17.07.2018 DE 102018211900
(43) Veröffentlichungstag der Anmeldung: 22.01.2020
(73) Patentinhaber: Siemens Energy Global GmbH & Co. KG, 81739 München (DE)
(72) Erfinder: Hohmann, Fabian, 36145 Hofbieber (DE); Bakran, Mark-Matthias, 91052 Erlangen (DE); Schuster, Dominik, 91456 Diespeck (DE)

(56) Entgegenhaltungen:
- WO-A1-2018/006970
- DE-A1- 10 245 288
- JP-A- 2004 158 485
- JP-A- 2015 002 564

## Beschreibung

Die Erfindung betrifft eine Halbleiteranordnung mit wenigstens zwei abschaltbaren Halbleiterschaltern, einem Energiespeicher, zwei äußeren Anschlüssen, wobei der Energiespeicher mit den Halbleiterschaltern derart verschaltet ist, dass an den Anschlüssen eine Spannung erzeugbar ist, die einer am Energiespeicher anstehenden Energiespeicherspannung oder einer Nullspannung entspricht, einem Schutzhalbleiter in einer Parallelschaltung zum Energiespeicher, einer Diodenreihenschaltung in einer weiteren Parallelschaltung zum Energiespeicher, wobei die Diodenreihenschaltung wenigstens zwei in Reihe angeordnete Dioden umfasst, wobei eine erste Diode der Diodenreihenschaltung dem ersten Halbleiterschalter und eine zweite Diode der Diodenreihenschaltung dem zweiten Halbleiterschalter antiparallel geschaltet sind, womit eine Durchlassrichtung der ersten Diode entgegen einer Durchlassrichtung des ersten Halbleiterschalters und eine Durchlassrichtung der zweiten Diode entgegen einer Durchlassrichtung des zweiten Halbleiterschalters gerichtet sind.

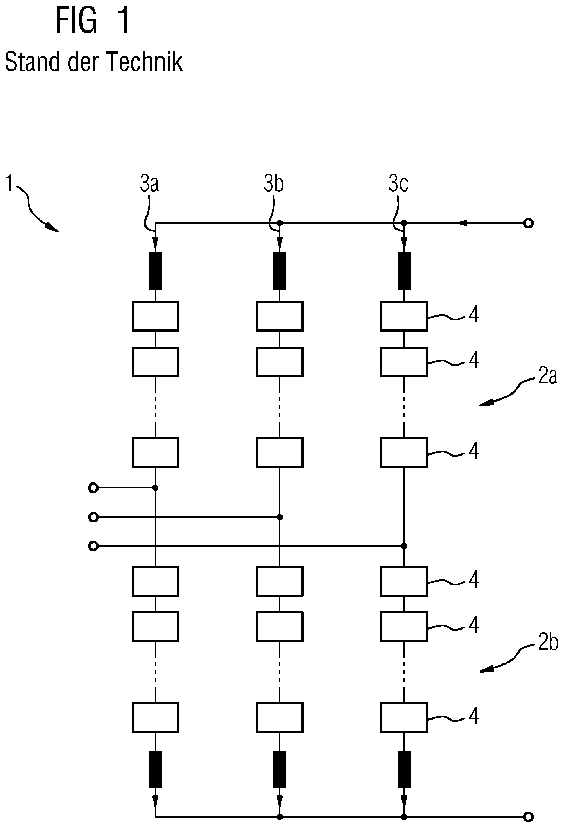

Halbleiteranordnungen dieser Art werden oft in modularen Mehrstufenumrichtern eingesetzt. Ein in Figur 1 dargestellter modularer Mehrstufenumrichter 1 umfasst in seinem Grundaufbau je zwei Konverterarme 2a, 2b pro Konverterphase 3a-c. Jeder Konverterarm umfasst dabei eine Serienschaltung zahlreicher Schaltmodule 4. Häufig verwendete Schaltmodultypen sind Schaltmodule in Halbbrückenschaltung bzw. in Vollbrückenschaltung. Fällt ein Schaltmodul aus, so muss dieses überbrückt werden, um einen weiteren Betrieb des Mehrstufenumrichters bis zum nächsten Wartungsvorgang zu gewährleisten. Üblicherweise werden zur Überbrückung der Schaltmodule mechanische Überbrückungsschalter eingesetzt.

Neben dem Normalbetrieb des Mehrstufenumrichters ist es erforderlich, dass die Halbleiteranordnung selbst bei Auftreten eines Fehlers nicht komplett zerstört wird. Einen besonders kritischen Fehler kann in bestimmten Konfigurationen ein gleichspannungsseitiger Kurzschluss darstellen. Beispielsweise bei Schaltmodulen in Halbbrückenschaltung erzeugt hierbei die AC-seitig eingeprägte Netzspannung einen hohen Kurzschlussstrom in den DC-Fehler hinein. Dieser fließt ungesteuert über die Diodenreihenschaltung. Die Komponenten der Schaltung müssen diesen hohen Fehlerstrom schadlos überstehen, bis er extern (i.A. durch AC-seitig installierte Leistungsschalter) geklärt/abgeschaltet worden ist. Üblicherweise werden bei den bekannten Halbleiteranordnungen Diodenchips eingesetzt, die mittels Bonddrähten mit den übrigen Bauteilen verbunden sind. Die Dioden weisen dabei nur eine geringe thermische Kapazität auf, die in einem Fehlerfall nicht ausreichend ist, um eine mögliche Zerstörung der Halbleiteranordnung zu vermeiden. Üblicherweise wird daher die besonders belastete Diode durch ein parallel angeordnetes zusätzliches Schutzbauelement entlastet.

Eine artgemäße Halbleiteranordnung ist beispielsweise aus der DE 103 23 220 B4 bekannt. Die bekannte Halbleiteranordnung bildet eine Vollbrückenschaltung zur Ausbildung eines Schaltmoduls eines modularen Matrixumrichters aus. In einem Fehlerfall des Schaltmoduls wird der Schutzhalbleiter in Abhängigkeit von einem Kurzschlussstrom des Energiespeichers derart angesteuert, dass er dauerhaft durchlegiert, wobei parallel zum Energiespeicher ein Kurzschlusspfad bereitgestellt ist.

Eine Anordnung eines modularen Mehrstufenumrichter in der power stack-Technologie, bei der alle Halbleiter in einem Spannverband angeordnet sind, ist aus der WO 2018/006970 A1 bekannt.

Der vorliegenden Erfindung liegt die Aufgabe zugrunde, eine Halbleiteranordnung der eingangs genannten Art vorzuschlagen, die möglichst kostengünstig und zuverlässig ist.

Die Aufgabe wird bei einer artgemäßen Halbleiteranordnung erfindungsgemäß nach Anspruch 1 dadurch gelöst, dass die Dioden der Diodenreihenschaltung Scheibenzellendioden sind, die in wenigstens einem Diodenspannverband mechanisch verspannt sind. Die Scheibenzellendioden können in einem gemeinsamen Diodenspannverband miteinander mechanisch verspannt sein. Alternativ können die Scheibenzellendioden einzeln in jeweils einem Diodenspannverband mechanisch verspannt sein.

Scheibenzellendioden weisen aufgrund einer relativ großen Fläche eine höhere thermische Kapazität auf. Dies senkt vorteilhaft das Risiko einer Zerstörung der Halbleiteranordnung im Fehlerfall.

Zudem weisen die Scheibenzellendioden eine erhöhte Stromtragfähigkeit auf, so dass sie im Fehlerfall den Kurzschlussstrom führen können. Vorteilhaft kann somit auf die Bereitstellung des zuvor genannten Schutzbauelements parallel zu einer der Dioden verzichtet werden, was einen Kostenvorteil ermöglicht. Ferner kann mittels der Scheibenzellendioden in Zusammenwirkung mit dem Schutzhalbleiter im Fehlerfall eine Überbrückung der Halbleiteranordnung erreicht werden. Auf diese Weise kann vorteilhaft auf einen zusätzlichen Überbrückungsschalter verzichtet werden, wodurch sich ein weiterer Kostenvorteil ergibt.

Bevorzugt ist der Diodenspannverband räumlich zwischen dem Schutzhalbleiter und den Halbleiterschaltern angeordnet. Auf diese Weise sind die Scheibenzellendioden nah am Zwischenkreis des Energiespeichers angeordnet. Dadurch kann die maximale Verlustleistung an der Scheibenzellendiode vorteilhaft verringert werden.

Vorzugsweise ist der Schutzhalbleiter ein Thyristor. Thyristoren sind steuerbare Halbleiter. Durch die Verwendung des Thyristors kann eine Bereitstellung eines Kurzschlusspfades parallel zum Energiespeicher durch gezielte Ansteuerung des Thyristors im Fehlerfall erreicht werden. Bei dieser Variante kann beispielsweise der Thyristor im Fehlerfall gezündet werden, wobei der Thyristor vorzugsweise durch die im Energiespeicher gespeicherte Energie zerstört wird. Die Zündung des Thyristors kann dabei nach Unterschreiten einer vorab festgelegten Energiemenge im Energiespeicher erfolgen oder bei Überschreiten einer vorher bestimmten Stromanstiegsschwelle. Befindet sich nicht ausreichend Energie im Energiespeicher, so kann dieser im regulären Betrieb der Halbleiteranordnung über die Scheibenzellendioden aufgeladen werden.

Durch das Zünden des Schutzhalbleiters kann vorteilhaft eine Explosion der Halbleiteranordnung verhindert werden. Dadurch kann ein explosionssicheres Gehäuse für die Halbleiteranordnung eingespart werden.

Der Thyristor kann beispielsweise in einem Thyristorspannverband angeordnet sein. Die elektrische Kontaktierung erfolgt über den Thyristorspannverband. Mit dieser Ausgestaltung ist ein besonders zuverlässiger niederohmiger Kurzschlusspfad nach dem Durchlegieren des Thyristors bereitgestellt.

Es wird als vorteilhaft angesehen, wenn eine Kühlung für die Scheibenzellen bereitgestellt ist. Vorzugsweise sind die Scheibenzellendioden jeweils beidseitig gekühlt. Im Diodenspannverband können beispielsweise benachbart zu jeder Scheibenzellendiode Kühlelemente vorhanden sein. Die Kühlelemente können zum Beispiel Kühlplatten sein, die geeigneterweise von einem Kühlmedium durchflossen sind. Durch die beidseitige Kühlung der Scheibenzellendioden kann vorteilhaft eine besonders hohe Leistung durch die Scheibenzellendioden geführt werden.

Geeigneterweise weist die Halbleiteranordnung einen ersten Gleichspannungspol auf, der mit einem ersten Anschluss des Energiespeichers verbunden ist, und einen zweiten Gleichspannungspol, der mit einem zweiten Anschluss des Energiespeichers verbunden ist, wobei die Gleichspannungspole zumindest teilweise durch äußere Kühlplatten zum Kühlen der Halbleiteranordnung ausgebildet sind. Durch die Gleichspannungspole ist der Zwischenkreis der Halbleiteranordnung definiert. Die Kühlplatten werden demnach als elektrische Anschlüsse im Zwischenkreis verwendet, was einen besonders kompakten Aufbau der Halbleiteranordnung erlaubt.

Da die Diodenreihenschaltung zwischen den äußeren Kühlplatten verspannt ist, können die Kühlplatten vorteilhaft zur Kühlung der Scheibenzellendioden verwendet werden. Gemäß einer Ausführungsform der Erfindung sind ein erster der Halbleiterschalter zwischen dem ersten Gleichspannungspol und einem äußeren Wechselspannungsanschluss der Halbleiteranordnung und ein zweiter der Halbleiterschalter zwischen dem äußeren Wechselspannungsanschluss der Halbleiteranordnung und dem zweiten Gleichspannungspol angeordnet. Der äußere Wechselspannungsanschluss dient zur Verbindung der Halbleiteranordnung beispielsweise mit einer weiteren Halbleiteranordnung zur Bildung einer Reihenschaltung. Die Halbleiteranordnung weist geeigneterweise einen weiteren äußeren Wechselspannungsanschluss, dessen Anordnung von der Ausgestaltung der Halbleiteranordnung abhängt. Beispielsweise kann der weitere Wechselspannungsanschluss direkt mit einem der Gleichspannungspole verbunden sein. Die Halbleiterschalter sind demnach einander gegenüber angeordnet und können beispielsweise mittels der äußeren Kühlplatten jeweils an die Gleichspannungspole angebunden sein. Diese Ausführungsform erlaubt einen besonders kompakten und robusten Aufbau der Halbleiteranordnung.

Die Halbleiteranordnung kann beispielsweise eine Halbbrückenschaltung oder eine Vollbrückenschaltung ausbilden. Diese Schaltungen sind dem Fachmann als besonders effektiv bekannt und insbesondere für einen Einsatz in einem modularen Mehrstufenumrichter geeignet.

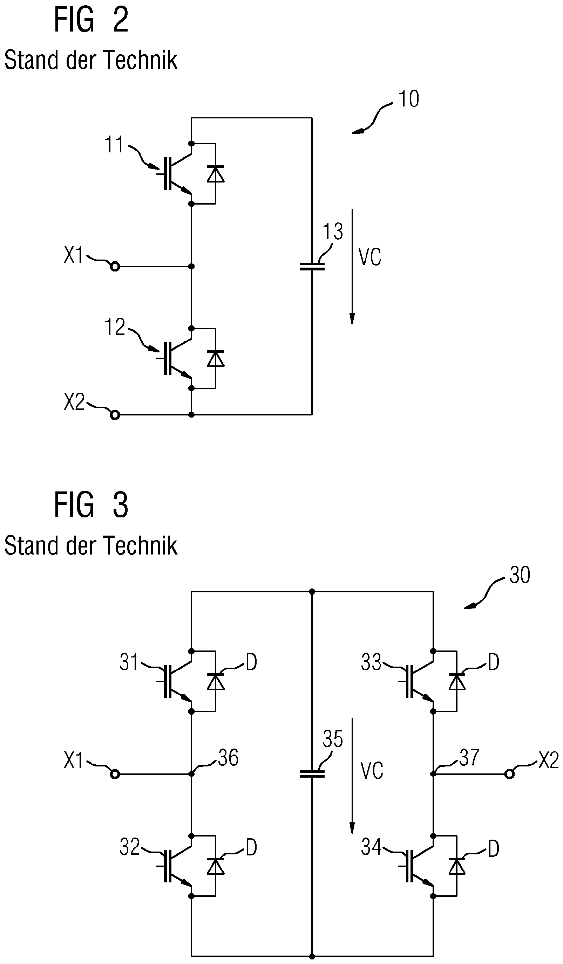

Ein Schaltmodul in Halbbrückenschaltung 10 ist in Figur 2 dargestellt. Die Halbbrückenschaltung 10 weist zwei abschaltbare Halbleiterschalter 11, 12 (im dargestellten Fall sind es IGBT-Schalter, wobei im Allgemeinen auch andere abschaltbare Halbleiterschalter, wie IGCT oder dergleichen verwendet werden können) und den Energiespeicher 13 auf, wobei die Halbleiterschalter 11, 12 so mit dem Energiespeicher 13 verschaltet sind, dass an den Ausgangsklemmen X1, X2 des Schaltmoduls, die auch als Wechselspannungsanschlüsse bezeichnet werden können, eine an dem Energiespeicher 13 abfallende Energiespeicherspannung Vc oder eine Nullspannung erzeugbar ist.

Ein Schaltmodul in Vollbrückenschaltung 30 ist in Figur 3 dargestellt. Die Vollbrückenschaltung 30 weist einen ersten Halbleiterschalter 31 sowie einen zweiten Halbleiterschalter 22, beide in Form von IGBTs. Die Durchlassrichtung der beiden Halbleiterschalter 31 und 32 ist gleichgerichtet. Ferner umfasst die Vollbrückenmodulschaltung 30 einen dritten Halbleiterschalter 33 sowie einen vierten Halbleiterschalter 34, beide ebenfalls in Form von IGBTs. Die IGBTs können durch andere abschaltbare Halbleiterschalter ersetzt werden. Die Durchlassrichtung der beiden Halbleiterschalter 33 und 34 ist gleichgerichtet. Ein Schaltmodulkondensator 35 ist parallel zu den beiden Reihenschaltungen der Halbleiterschalter angeordnet. Der erste Anschluss X1 ist an einem Potenzialpunkt 36 zwischen den Halbleiterschaltern 31, 32 angeordnet, der zweite Anschluss X2 ist an einem Potenzialpunkt 37 zwischen den Halbleiterschaltern 33, 34 angeordnet. Jedem der Halbleiterschalter 31-34 ist je eine Freilaufdiode D antiparallel geschaltet. Durch eine geeignete Steuerung der Leistungshalbleiter 31-34 kann die an den Anschlüssen X1, X2 abfallende Spannung erzeugt werden, die der am Schaltmodulkondensator 35 abfallenden Spannung Vc, der am Schaltmodulkondensator 35 abfallenden Spannung jedoch mit entgegengesetzter Polarität (-Vc) oder der Nullspannung entspricht.

Weitere Arten von Schaltmodulen sind beispielsweise das sogenannte Double-Clamp Submodule, das in dem Beitrag "Modular Multilevel Converter: A Universal Concept for HVDC-Networks and Extended DC-Bus-Applications" von R. Marquardt beschrieben ist, das sogenannte Five-Level Cross Connected Submodule, bekannt aus dem Beitrag "Five Level Cross Connected Cell for Cascaded Converters" von A. Nami et al. und das Double-Submodule Circuit, das in dem Beitrag "A Submodule Implementation for Parallel Connection of Capacitors in Modular Multilevel Converters" von K. Ilves et al. offenbart ist.

Die Erfindung betrifft ferner ein Schaltmodul für einen modularen Mehrstufenumrichter.

Solche Schaltmodule sind, wie bereits oben ausgeführt, aus dem Stand der Technik bekannt.

Die Aufgabe der Erfindung besteht darin, ein artgemäßes Schaltmodul bereitzustellen, das einen möglichst zuverlässigen Betrieb des Mehrstufenumrichters ermöglich und zugleich möglichst kostengünstig ist.

Die Aufgabe wird erfindungsgemäß durch ein artgemäßes Schaltmodul gelöst, das eine erfindungsgemäße Halbleiteranordnung umfasst.

Die Vorteile des erfindungsgemäßen Schaltmoduls ergeben sich sinngemäß aus den bereits beschriebenen Vorteilen der erfindungsgemäßen Halbleiteranordnung.

Das Schaltmodul umfasst zweckmäßigerweise weitere Bauteile, wie beispielsweise eine Ansteuerschaltung und/oder Kommunikationseinrichtung, die für den Betrieb des Schaltmoduls in einem modularen Mehrstufenumrichter ausgelegt und eingerichtet sind.

Des Weiteren betrifft die Erfindung einen modularen Mehrstufenumrichter.

Modulare Mehrstufenumrichter (MMC) sind, wie bereits ausgeführt, aus dem Stand der Technik bekannt. Jedes der Schaltmodule des modularen Mehrstufenumrichters ist mittels einer Ansteuereinrichtung einzeln ansteuerbar. Eine an einem der Konverterarme abfallende Spannung ist gleich der Summe von Spannungen, die an den zugehörigen Schaltmodulen abfallen. Mittels des MMC ist eine besonders vorteilhafte stufenförmige Konverterspannung an dessen Wechselspannungsanschluss erzeugbar.

Die Aufgabe der Erfindung besteht darin, einen modularen Mehrstufenumrichter vorzuschlagen, der möglichst kostengünstig und zuverlässig ist.

Die Aufgabe wird bei einem modularen Mehrstufenumrichter dadurch gelöst, dass der modulare Mehrstufenumrichter eine Reihenschaltung der erfindungsgemäßen Schaltmodule umfasst.

Die Vorteile des erfindungsgemäßen modularen Mehrstufenumrichters ergeben sich aus den bereits beschriebenen Vorteilen der erfindungsgemäßen Schaltmodule.

Zudem betrifft die Erfindung eine Hochspannungsgleichstromübertragungsanlage mit einem modularen Mehrstufenumrichter.

Solche Hochspannungsgleichstromübertragungsanlagen sind aus dem Stand der Technik, beispielsweise aus der WO 2016/155 850 A1 bekannt. Sie werden üblicherweise zur Kopplung von Wechselspannungsnetzen eingesetzt, wobei die elektrischen Verluste bei einer Leistungsübertragung zwischen den Wechselspannungsnetzen vorteilhaft niedrig sind.

Die Aufgabe der Erfindung ist es, eine artgemäße Hochspannungsgleichstromübertragungsanlage bereitzustellen, die möglichst zuverlässig in Betrieb und kostengünstig in Herstellung ist.

Die Aufgabe wird erfindungsgemäß dadurch gelöst, dass der modulare Mehrstufenumrichter der erfindungsgemäßen Hochspannungsgleichstromübertragungsanlage ein erfindungsgemäßer modularer Mehrstufenumrichter ist.

Die Vorteile der erfindungsgemäßen Hochspannungsgleichstromübertragungsanlage ergeben sich aus den bereits beschriebenen Vorteilen des erfindungsgemäßen modularen Mehrstufenumrichters.

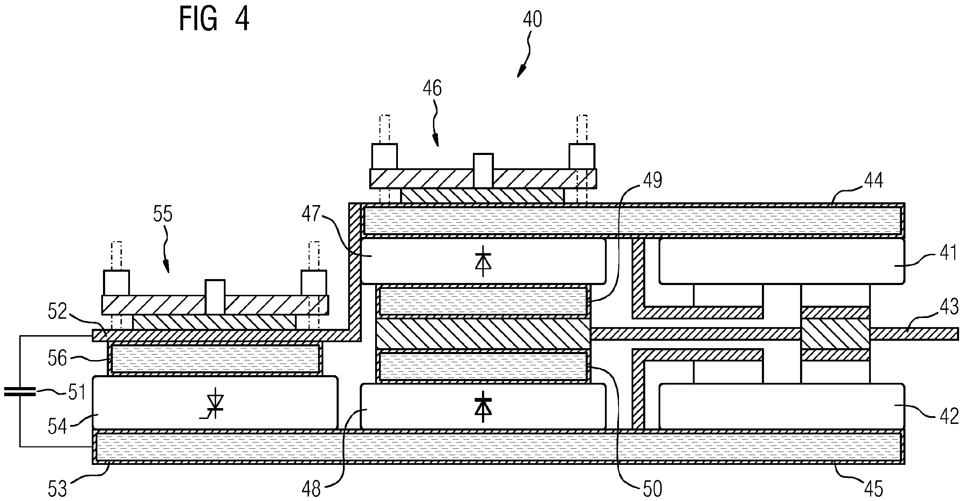

Die Erfindung wird im Folgenden anhand der Figur 4 weiter erläutert.

Figur 4 zeigt ein Ausführungsbeispiel einer erfindungsgemäßen Halbleiteranordnung in einer schematischen Seitendarstellung.

In Figur 4 ist eine Halbleiteranordnung 40 dargestellt. Die Halbleiteranordnung 40 umfasst einen ersten abschaltbaren Halbleiterschalter 41 in Form eines IGBTs und einen zweiten abschaltbaren Halbleiterschalter 42 ebenfalls in Form eines IGBTs. Die beiden Halbleiterschalter 41, 42 sind als Chips auf einem Substrat angeordnet und chipseitig einander zugewandt. Zwischen den Halbleiterschaltern 41, 42 ist ein Wechselspannungsanschluss 43 der Halbleiteranordnung 40 angeordnet. Zur Kühlung der beiden Halbleiterschalter 41, 42 ist jeweils eine äußere Kühlplatte 44 bzw. 45 vorgesehen. Der Wechselspannungsanschluss 43 und die äußere Kühlplatte 44 bilden die beiden äußeren Anschlüsse der Halbleiteranordnung 40. Zwischen den beiden Kühlplatten 44, 45 ist ein Diodenspannverband 46 mechanisch verspannt. Der Diodenspannverband 46 umfasst miteinander elektrisch kontaktierte Scheibenzellendioden 47 und 48 in einer Diodenreihenschaltung, die als Freilaufdioden für die Halbleiterschalter 41, 42 dienen. Die Scheibenzellendioden 47, 48 sind jeweils mittels der Kühlplatten 44, 45 sowie Kühlscheiben 49, 50 beidseitig gekühlt.

Die Halbleiteranordnung 40 umfasst ferner einen Energiespeicher 51 in Form eines Zwischenkreiskondensators, dessen Anschlüsse zwei Gleichspannungspole 52 bzw. 53 der Halbleiteranordnung bilden.

Parallel zum Energiespeicher 51 ist ein Schutzhalbleiter in Form eines Schutzthyristors 54 in einem Thyristorspannverband 55 angeordnet. Der Schutzthyristor 54 ist mittels der äußeren Kühlplatte 45 und einer weiteren Kühlplatte 56 beidseitig gekühlt.

## Patentansprüche

1. Halbleiteranordnung (40) mit
- wenigstens zwei abschaltbaren Halbleiterschaltern (41, 42),
- einem Energiespeicher (51),
- zwei äußeren Anschlüssen (43, 44), wobei der Energiespeicher (51) mit den Halbleiterschaltern (41, 42) derart verschaltet ist, dass an den Anschlüssen (43, 44) eine Spannung erzeugbar ist, die einer am Energiespeicher (51) anstehenden Energiespeicherspannung oder einer Nullspannung entspricht,
- einem Schutzhalbleiter (54) in einer Parallelschaltung zum Energiespeicher (51),
- einer Diodenreihenschaltung (47, 48) in einer weiteren Parallelschaltung zum Energiespeicher (51), wobei die Diodenreihenschaltung (47, 48) wenigstens zwei in Reihe angeordnete Dioden (47, 48) umfasst, wobei eine erste Diode (47) der Diodenreihenschaltung dem ersten Halbleiterschalter (41) und eine zweite Diode (48) der Diodenreihenschaltung dem zweiten Halbleiterschalter (42) antiparallel geschaltet sind,
wobei die Dioden (47, 48) der Diodenreihenschaltung Scheibenzellendioden sind, die in wenigstens einem Diodenspannverband mechanisch verspannt sind,
**dadurch gekennzeichnet, dass** die beiden Halbleiterschalter (41, 42) als Chips auf einem Substrat angeordnet und chipseitig einander zugewandt sind, zur Kühlung der beiden Halbleiterschalter (41, 42) jeweils eine äußere Kühlplatte (44, 45) vorgesehen ist, wobei zwischen den beiden Kühlplatten (44, 45) der Diodenspannverband (46) mechanisch verspannt ist, wobei der Diodenspannverband räumlich zwischen dem Schutzhalbleiter (54) und den Halbleiterschaltern (41, 42) angeordnet ist, und wobei die Kühlplatten als elektrische Anschlüsse in einem Zwischenkreis des Energiespeichers (51) verwendet werden.

2. Halbleiteranordnung (40) nach Anspruch 1, wobei der Diodenspannverband (46) räumlich zwischen dem Schutzhalbleiter (54) und den Halbleiterschaltern (41, 42) angeordnet ist.

3. Halbleiteranordnung (40) nach einem der vorangehenden Ansprüche, wobei der Schutzhalbleiter (54) ein Thyristor ist.

4. Halbleiteranordnung (40) nach Anspruch 3, wobei der Thyristor (54) in einem Thyristorspannverband (55) angeordnet ist.

5. Halbleiteranordnung (40) nach einem der vorangehenden Ansprüche, wobei die Scheibenzellendioden jeweils beidseitig gekühlt sind.

6. Halbleiteranordnung (40) nach einem der vorangehenden Ansprüche, wobei die Halbleiteranordnung (40) einen ersten Gleichspannungspol (52) aufweist, der mit einem ersten Anschluss des Energiespeichers verbunden ist, und einen zweiten Gleichspannungspol (53) aufweist, der mit einem zweiten Anschluss des Energiespeichers verbunden ist, wobei die Gleichspannungspole zumindest teilweise durch äußere Kühlplatten (44, 45) zum Kühlen der Halbleiteranordnung ausgebildet sind.

7. Halbleiteranordnung (40) nach einem der vorangehenden Ansprüche, wobei die Scheibenzellendioden (47, 48) jeweils mittels der Kühlplatten (44, 45) sowie Kühlscheiben (49, 50) beidseitig gekühlt sind.

8. Halbleiteranordnung (40) nach einem der vorangehenden Ansprüche, wobei ein erster der Halbleiterschalter (41) zwischen dem ersten Gleichspannungspol (52) und einem äußeren Wechselspannungsanschluss (43) der Halbleiteranordnung und ein zweiter der Halbleiterschalter (42) zwischen dem äußeren Wechselspannungsanschluss (43) der Halbleiteranordnung (40) und dem zweiten Gleichspannungspol (53) angeordnet sind.

9. Halbleiteranordnung (40) nach einem der vorangehenden Ansprüche, wobei die Halbleiteranordnung (40) eine Halbbrückenschaltung oder eine Vollbrückenschaltung ausbildet.

10. Schaltmodul (10, 30) für einen modularen Mehrstufenumrichter, wobei das Schaltmodul eine Halbleiteranordnung nach einem der Ansprüche 1 bis 8 umfasst.

11. Modularer Mehrstufenumrichter (1) mit einer Reihenschaltung von Schaltmodulen nach Anspruch 9.

12. Hochspannungsgleichstromübertragungsanlage mit einem modularen Mehrstufenumrichter (1) nach Anspruch 10.

## Claims

1. Semiconductor arrangement (40) comprising
- at least two turn-off semiconductor switches (41, 42),
- an energy store (51),
- two external terminals (43, 44), wherein the energy store (51) is interconnected with the semiconductor switches (41, 42) in such a way that a voltage corresponding to an energy store voltage present at the energy store (51) or to a zero voltage is able to be generated at the terminals (43, 44),
- a protective semiconductor (54) connected to the energy store (51) in a parallel circuit,
- a diode series circuit (47, 48) connected to the energy store (51) in a further parallel circuit, wherein the diode series circuit (47, 48) comprises at least two diodes (47, 48) arranged in series, wherein a first diode (47) of the diode series circuit is connected in antiparallel with the first semiconductor switch (41) and a second diode (48) of the diode series circuit is connected in antiparallel with the second semiconductor switch (42),
wherein the diodes (47, 48) of the diode series circuit are disc-type diodes that are mechanically clamped in at least one diode clamping assembly,
**characterized in that**
the two semiconductor switches (41, 42) are arranged as chips on a substrate and face one another on the chip side, a respective external cooling plate (44, 45) is provided for cooling the two semiconductor switches (41, 42), wherein the diode clamping assembly (46) is mechanically clamped between the two cooling plates (44, 45), wherein the diode clamping assembly is arranged spatially between the protective semiconductor (54) and the semiconductor switches (41, 42), and wherein the cooling plates are used as electrical terminals in a link circuit of the energy store (51).

2. Semiconductor arrangement (40) according to Claim 1, wherein the diode clamping assembly (46) is arranged spatially between the protective semiconductor (54) and the semiconductor switches (41, 42).

3. Semiconductor arrangement (40) according to either of the preceding claims, wherein the protective semiconductor (54) is a thyristor.

4. Semiconductor arrangement (40) according to Claim 3, wherein the thyristor (54) is arranged in a thyristor clamping assembly (55).

5. Semiconductor arrangement (40) according to any of the preceding claims, wherein the disc-type diodes are each cooled on both sides.

6. Semiconductor arrangement (40) according to any of the preceding claims, wherein the semiconductor arrangement (40) has a first DC voltage pole (52), which is connected to a first terminal of the energy store, and has a second DC voltage pole (53), which is connected to a second terminal of the energy store, wherein the DC voltage poles are embodied at least partly by outer cooling plates (44, 45) for cooling the semiconductor arrangement.

7. Semiconductor arrangement (40) according to any of the preceding claims, wherein the disc-type diodes (47, 48) are each cooled on both sides by means of the cooling plates (44, 45) and also cooling discs (49, 50).

8. Semiconductor arrangement (40) according to any of the preceding claims, wherein a first of the semiconductor switches (41) is arranged between the first DC voltage pole (52) and an external AC voltage terminal (43) of the semiconductor arrangement and a second of the semiconductor switches (42) is arranged between the external AC voltage terminal (43) of the semiconductor arrangement (40) and the second DC voltage pole (53).

9. Semiconductor arrangement (40) according to any of the preceding claims, wherein the semiconductor arrangement (40) forms a half-bridge circuit or a full-bridge circuit.

10. Switching module (10, 30) for a modular multilevel converter, wherein the switching module comprises a semiconductor arrangement according to any of Claims 1 to 8.

11. Modular multilevel converter (1) comprising a series circuit formed by switching modules according to Claim 9.

12. High-voltage direct current transmission installation comprising a modular multilevel converter (1) according to Claim 10.

## Revendications

1. Montage (40) de semiconducteurs comprenant
- au moins deux interrupteurs (41, 42) à semiconducteur pouvant être ouverts,
- un accumulateur (51) d'énergie,
- deux bornes (43, 44) extérieures, l'accumulateur (51) d'énergie étant connecté aux interrupteurs (41, 42) à semiconducteur, de manière à pouvoir produire aux bornes (43, 44) une tension, qui correspond à une tension d'accumulateur d'énergie aux bornes de l'accumulateur (51) d'énergie ou à une tension nulle,
- un semiconducteur (54) de protection dans un circuit en parallèle avec l'accumulateur (51) d'énergie,
- un circuit (47, 48) série de diodes dans un autre circuit en parallèle avec l'accumulateur (51) d'énergie, dans lequel le circuit (47, 48) série de diodes comprend au moins deux diodes (47, 48) montées en série, dans lequel une première diode (47) du circuit en série de diodes est montée tête bêche avec le premier interrupteur (41) à semiconducteur et une deuxième diode (48) du circuit en série de diodes est montée tête bêche avec le deuxième interrupteur (42) à semiconducteur,
dans lequel les diodes (47, 48) du circuit série de diodes sont des diodes à disque, qui sont bloquées mécaniquement dans au moins un assemblage de blocage de diodes,
**caractérisé en ce que**
les deux interrupteurs (41, 42) à semiconducteur sont disposés sous la forme de puces sur un substrat et sont tournés l'un vers l'autre du côté puce, il est prévu pour le refroidissement des deux interrupteurs (41, 42) à semiconducteur respectivement une plaque (44, 45) extérieure de refroidissement, dans lequel l'assemblage de blocage de diodes est bloqué mécaniquement entre les deux plaques (44, 45) de refroidissement, dans lequel l'assemblage (46) de blocage de diodes est disposé dans l'espace entre le semiconducteur (54) de protection et les interrupteurs (41, 42) à semiconducteur et dans lequel les plaques de refroidissement sont utilisées comme bornes électriques d'un circuit intermédiaire de l'accumulateur (51) d'énergie.

2. Montage (40) de semiconducteurs suivant la revendication 1, dans lequel l'assemblage (46) de blocage de diodes est disposé dans l'espace entre le semiconducteur (54) de protection et les interrupteurs (41, 42) à semiconducteur.

3. Montage (40) de semiconducteurs suivant l'une des revendications précédentes, dans lequel le semiconducteur (54) de protection est un thyristor.

4. Montage (40) de semiconducteurs suivant la revendication 3, dans lequel le thyristor (54) est disposé dans un assemblage (55) de blocage de thyristor.

5. Montage (40) de semiconducteurs suivant l'une des revendications précédentes, dans lequel les diodes à disque sont refroidies respectivement des deux côtés.

6. Montage (40) de semiconducteurs suivant l'une des revendications précédentes, dans lequel le montage (40) de semiconducteurs a un premier pôle (52) de tension continue, qui est relié à une première borne de l'accumulateur d'énergie, et un deuxième pôle (53) de tension continue, qui est relié à une deuxième borne de l'accumulateur d'énergie, dans lequel les pôles de tension continue sont constitués au moins en partie par des plaques (44, 45) extérieures de refroidissement pour refroidir le montage de semiconducteurs.

7. Montage (40) de semiconducteurs suivant l'une des revendications précédentes, dans lequel les diodes (47, 48) à disque sont refroidies des deux côtés chacune au moyen des plaques (44, 45) de refroidissement, ainsi que de disques (49, 50) de refroidissement.

8. Montage (40) de semiconducteurs suivant l'une des revendications précédentes, dans lequel un premier des interrupteurs (41) de semiconducteurs est monté entre le premier pôle (52) de tension continue et une borne (43) extérieure de tension alternative du montage à semiconducteur et un deuxième des interrupteurs (42) à semiconducteur est monté entre la borne (43) extérieure de tension alternative du montage (40) de semiconducteurs et le deuxième pôle (53) de tension continue.

9. Montage (40) de semiconducteurs suivant l'une des revendications précédentes, dans lequel le montage (40) de semiconducteurs constitue un montage à demi-pont ou un montage à pont complet.

10. Module (10, 30) de commutation pour un convertisseur modulaire à plusieurs étages, dans lequel le module de commutation comprend un montage de semiconducteurs suivant l'une des revendications 1 à 8.

11. Convertisseur (1) modulaire à plusieurs étages ayant un circuit série de modules de commutation suivant la revendication 9.

12. Installation de transport de courant continu sous haute tension, comprenant un convertisseur (1) modulaire à plusieurs étages suivant la revendication 10.
